# EUROPEAN PATENT APPLICATION

(11) **EP 0 998 028 A1**
(43) Date of publication of application: **03.05.2000**
(21) Application number: 99308209.8
(22) Date of filing: 18.10.1999
(51) Int. Cl.: H03F 1/32

(54) **Feedforward amplifier**

(30) Priority: 30.10.1998 US 182640
(71) Applicant: LUCENT TECHNOLOGIES INC., Murray Hill, New Jersey 07974-0636 (US)
(72) Inventor: Ziesse, Norman G., Chester, New Jersey 07930 (US)
(74) Representative: Buckley, Christopher Simon Thirsk

(57) **Abstract**

A feedforward amplifier (40A) and an amplification method using the feedforward amplifier include an equalizer (48) positioned in series with a main amplifier (50) and/or a correction amplifier of the feedforward amplifier to compensate for a non-flat frequency response of the main amplifier and/or correction amplifier. The equalizer can be a voltage controllable equalizer adjustable under electronic controls to accommodate changing circuit conditions, or an equalizer with fixed parameters. These equalizers are selectively used according to the need and desired performance. The feedforward amplifier and the method separately perform the equalization function and the linearizing function of the feedforward amplifier to provide a cost effective and efficient feedforward amplifier and amplification method.

## Description

### Field of the Invention

The present invention relates to a feedforward amplifier and a method of amplifying signals using the feedforward amplifier.

### Description of Related Art

Feedforward types of linear RF power amplifiers are used in multi-signal applications which require a high degree of amplifier linearity to prevent intermodulation distortions. Particularly, feedforward RF power amplifiers that are small in size and low in cost are needed in cellular or personal communication service/system (PCS) base stations.

A conventional feedforward power amplifier, generally used in cellular or PCS base stations, generates an amplified signal composed of an ideally amplified input signal and an error signal. The error signal arises due to imperfections in the device and the environment.

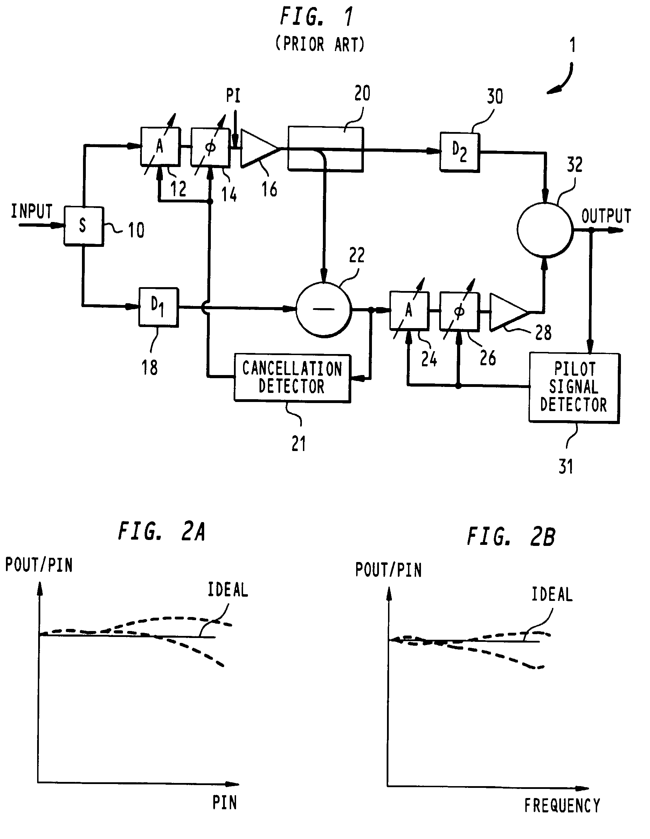

Fig. 1 shows a block diagram of a conventional feedforward amplifier. As shown therein, one example of a conventional feedforward amplifier 1 includes a splitter 10 for receiving an input signal, an amplitude adjuster 12 connected to the splitter 10, a phase adjuster 14 connected to the amplitude adjuster 12, a cancellation detector 21 for adaptively controlling the amplitude and phase adjusters 12 and 14, a main amplifier 16 connected to the phase adjuster 14, a directional coupler 20 for distributing an output of the main amplifier 16, a first delay unit 18 connected to the splitter 10, a second delay unit 30 connected to the coupler 20, a subtracter 22 connected to the first delay unit 18, an amplitude adjuster 24 connected to the subtracter 22, a phase adjuster 26 connected to the amplitude adjuster 24, a pilot signal detector 31 for adaptively controlling the amplitude and phase adjusters 24 and 26, a correction amplifier 28 connected to the phase adjuster, and a combiner 32 connected to the second delay unit 30 and the correction amplifier 28 for generating an output signal.

The splitter 10 divides the input signal into two, and outputs a first divided input signal to the amplitude adjuster 12 and a second divided input signal to the first delay unit 18. The amplitude and phase adjusters 12 and 14 respectively adjust the amplitude and phase of the first divided input signal across the entire frequency band under control of the cancellation detector 21. The main amplifier 16 amplifies the output of the phase adjuster 14, and outputs the amplified input signal to the directional coupler 20. The directional coupler 20 directs the amplified input signal to the second delay unit 30 and the subtracter 22. The amplified input signal is composed of an ideally amplified signal and an error signal introduced due to imperfections in the system and the environment.

The second divided input signal from the splitter 10 is delayed by the first delay unit 18 for a predetermined time period and input to the subtracter 22. The subtracter 22 subtracts the signal output from the first delay unit 18 from the amplified input signal output from the directional coupler 20. The resultant signal represents an error signal introduced by the main amplifier 16. This error signal is detected and monitored by the cancellation detector 21. Based on the detection, the cancellation detector 21 controls the parameters of the amplitude and phase adjusters 12 and 14 so that a reduced error signal can be output from the combiner 32.

The amplitude and phase adjusters 24 and 26 respectively adjust the amplitude and phase of the error signal across the entire frequency band under control of the pilot signal detector 31. To control the amplitude and phase adjusters 24 and 26, a pilot signal PI is injected at the input of the main amplifier 16, and the injected pilot signal PI is monitored and detected by the pilot signal detector 31 at the output of the combiner 32. This pilot signal PI typically is a pulse at a designated frequency. Based on the detection, the pilot signal detector 31 controls the parameters of the amplitude and phase adjusters 24 and 26 to minimize an error signal included in the output of the combiner 32.

The correction amplifier 28 amplifies the output of the phase adjuster 26. To the extent that the correction amplifier 28 does not add its own error signal to the error signal input to the correction amplifier 28, the output of the correction amplifier 28 is available to cancel the error signal included in the amplified input signal. The amplified input signal from the directional coupler 20 is delayed for a predetermined time period by the second delay unit 30 before it is output to the combiner 32.

The combiner 32 adds the amplified input signal from the second delay unit 30 and the amplified error signal output from the correction amplifier 28. If the gains, phases and delays in the system are properly set, the error signal from the correction amplifier 28 is equal in amplitude, but 180° out of phase, with the error signal included in the output of the main amplifier 16. By adding the output of the main amplifier 16 with the error signal from the correction amplifier 28 in the combiner 32, the error signal included in the output of the combiner 32 can be reduced.

The error signal included in the output of the main amplifier 16 has two main components: 1) a non-linear distortion component and 2) a non-flat frequency response component, introduced due to imperfections in the system and environment. Ideally, the gain (Pout/Pin where Pout is the output signal power and Pin is the input signal power) of the main amplifier 16 should be constant as shown in, e.g., Fig. 2A, but the actual gain has a non-linear component as indicated by the dotted line. Similarly, although a flat frequency response of the main amplifier 16 is ideally desired as shown by the solid line in Fig. 2B, the actual frequency response of the main amplifier 16 is typically not flat as indicated by the dotted line in Fig. 2B. Between the non-linear error component and the non-flat frequency response error component, the non-flat frequency response error component of the overall error signal can dominate the entire characteristic of the overall error signal, especially when the operating bandwidth of the amplifier 1 is wide.

In the past, in order to correct the effects of these two components of the error signal in conventional feedforward amplifiers, great care and expense was dedicated to designing a main amplifier having a very flat frequency response. Further, a larger and more powerful correction amplifier was used to compensate for the remaining non-flat frequency response of the main amplifier. However, since the design of the correction amplifier has a predominant effect on the overall efficiency of the feedforward amplifier and both main and correction amplifiers determine the final cost of a power amplifier, a technique for simultaneously improving both the cost and efficiency of a power amplifier is needed.

### Summary Of The Invention

The present invention is directed to a feedforward amplifier and a method of amplifying signals using the feedforward amplifier. The feedforward amplifier and its method include an equalizer positioned in series with a main amplifier and/or a correction amplifier to compensate for a non-flat frequency response of the main amplifier and/or correction amplifier. The equalizer can be a voltage controllable equalizer adjustable under electronic controls to accommodate changing circuit conditions, or an equalizer with fixed parameters. These equalizers are selectively used according to the need and desired performance. The present feedforward amplifier and the method separately perform the equalization function from the linearizing function of the feedforward amplifier to provide a cost effective feedforward amplifier and method of amplifying signals.

### Brief Description Of The Drawings

The present invention will become more fully understood from the detailed description given hereinbelow and the accompanying drawings which are given by way of illustration only, wherein reference numerals designate corresponding parts in the various drawings and wherein:
Fig. 1 shows a block diagram of a conventional feedforward amplifier;
Fig. 2A shows a graph illustrating a gain characteristic of a conventional non-feedforward amplifier, such as the main amplifier 16 in Fig. 1;
Fig. 2B shows a graph illustrating a frequency response of the conventional non-feedforward amplifier, such as the main amplifier 16 in Fig. 1;
Fig. 3 shows a block diagram of a feedforward amplifier having a voltage controllable equalizer and an equalizer with fixed parameters according to a first embodiment of the present invention;
Fig. 4 shows a block diagram of a feedforward amplifier having two equalizers with fixed parameters according to a second embodiment of the present invention;
Fig. 5 shows a block diagram of a feedforward amplifier having two voltage controllable equalizers according to a third embodiment of the present invention; and
Fig. 6 shows a block diagram of a feedforward amplifier having an equalizer with fixed parameters and a voltage controllable equalizer according to a fourth embodiment of the present invention.

### Detailed Description Of The Preferred Embodiments

The following detailed description relates to a feedforward amplifier and its amplification method with an increased efficiency, a lower cost, and a wider operational bandwidth. Elements having the same reference numerals in the figures have the same structure and functions.

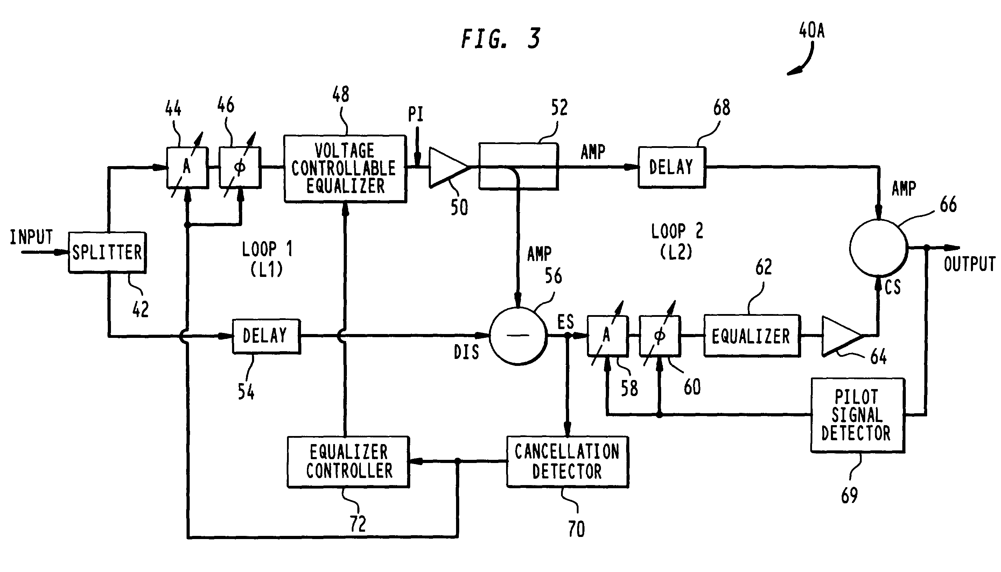

Fig. 3 shows a block diagram of a feedforward amplifier having a voltage controllable equalizer and an equalizer with fixed parameters ("fixed equalizer") according to a first embodiment of the present invention. As shown therein, the feedforward amplifier 40A includes a splitter 42 for receiving an input signal, an amplitude adjuster 44 connected to the splitter 42, a phase adjuster 46 connected to the phase adjuster 46, a main amplifier 50, a voltage controllable equalizer 48 for precompensating the frequency response of the main amplifier 50, a directional coupler 52 connected to the main amplifier 50, a subtracter 56 connected to the coupler 52, and a first delay unit 54 connected to the splitter 42.

The feedforward amplifier 40A further includes a cancellation detector 70 connected to the subtracter 56, an equalizer controller 72 for controlling the voltage controllable equalizer 48, an amplitude adjuster 58 connected to the subtracter 56, a phase adjuster 60 connected to the amplitude adjuster 58, a fixed equalizer 62 connected to the phase adjuster 60, a correction amplifier 64 connected to the equalizer 62, a combiner 66 connected to the delay unit 68 and the correction amplifier 64, a pilot signal detector 69 connected to the combiner 66, and a second delay unit 68 connected to the coupler 52. The fixed equalizer 62 is an equalizer known in the art for flattening the frequency response of a broadband circuit and the parameters of such a fixed equalizer cannot be changed once they have been set during the manufacturing stage. The parameters of the fixed equalizer are permanently set to compensate for the non-flat frequency response of the correction amplifier 64. The voltage controllable equalizer 48 is a voltage controllable equalizer known in the art and its parameters are adjustable during the actual operation by varying voltage signals applied thereto. Here, the voltage controllable equalizer 62 is varied to optimize circuit operations in response to changes in parameters, e.g., temperature, input signal, supply voltage, etc. The voltage controllable equalizer 62, the equalizer controller 72, and the cancellation detector 70 form an adaptively controllable equalizing unit.

The operation of the feedforward amplifier 40A according to the first embodiment of the present invention will be described below referring to Fig. 3.

The splitter 42 receives an input signal, e.g., a RF signal, to be amplified and divides the input signal to generate first and second divided input signals. The first divided input signal is output to the amplitude adjuster 44 and the second divided input signal is output to the first delay unit 54.

The amplitude and phase adjusters 44 and 46 uniformly adjust the amplitude and phase of the first divided input signal across the entire frequency band. The cancellation detector 70 adaptively controls the amplitude and phase adjusters 44 and 46 as in the conventional feedforward amplifier 1 shown in Fig. 1. The voltage controllable equalizer 48 receives the output of the phase adjuster 46 and, under control of the equalizer controller 72, adjusts the gain and/or phase of the signal to correct the non-flat frequency response of the main amplifier 50. This allows a signal output from the main amplifier 50 to have a substantially flat frequency response component. The equalizer controller 72 controls the equalizer 48 to compensate for temperature fluctuation, mechanical aging, and other variations in the amplifier frequency response.

The main amplifier 50 amplifies the output of the voltage controllable equalizer 48 according to its predetermined gain to generate an amplified signal AMP. The amplified signal AMP is composed of an ideally amplified signal and an error signal introduced primarily because of non-linearities in the main amplifier 50 (e.g., as shown in Fig. 2A). The directional coupler 52 transmits the amplified signal AMP to the second delay unit 68 and the subtracter 56. The second delay unit 68 delays the amplified signal AMP for a predetermined time period to output the amplified signal AMP to the combiner 66 at a set time.

On the other hand, the first delay unit 54 receives the second divided input signal output from the splitter 42 and delays it for a predetermined time period to generate a delayed input signal DIS. The predetermined delay time of the first delay unit 54 corresponds to the process time of the amplitude adjuster 44, the phase adjuster 46, the voltage controllable equalizer 48, the main amplifier 50, and the directional coupler 52. As a result, the delayed input signal DIS and the amplified signal AMP arrive at the subtracter 56 at the same time. The subtracter 56 subtracts the delayed input signal DIS from the amplified signal AMP to separate and obtain an error signal ES introduced to the amplified signal AMP during the process in the first loop L1. The subtracter 56 outputs the error signal ES to the amplitude adjuster 58 and the cancellation detector 70.

In addition to controlling the amplitude and phase adjusters 44 and 46, the cancellation detector 70 also operates with the equalizer controller 72 to minimize the non-ideal frequency response component of the error signal ES. The amplitude and phase adjusters 44 and 46, and the equalizer 48 are adjusted by the cancellation detector 57, separately. The cancellation detector 70 detects the non-ideal frequency response component of the error signal ES and outputs a detection signal to the equalizer controller 72 based on its detection result. The equalizer controller 72 controls the voltage controllable equalizer 48 based on the detection signal by applying certain voltage signals to the equalizer 48 so that the non-ideal frequency response component of the error signal ES (included in the amplified signal AMP) is minimized. As a result, the error signal ES included in the output of the main amplifier 50 will contain primarily the non-linear component.

The amplitude adjuster 58 receives the error signal ES (whose non-ideal frequency response component has been reduced) from the subtracter 56. The amplitude and phase adjusters 58 and 60 uniformly adjust the amplitude and phase of the error signal ES across the entire frequency band under control of the pilot signal detector 69. To control the amplitude and phase adjusters 58 and 60, the pilot signal detector 69 monitors a signal at the output of the combiner 66 that results from a pilot signal PI being injected at the input of the main amplifier 50. The detector 69 sets the parameters of the amplitude and phase adjusters 58 and 60 based on the error detected in the signal from the combiner 66, as in the conventional feedfoward amplifier 1. The amplitude and phase adjusters 58 and 60 adjust the characteristics of the error signal ES so that the signal produced by the amplifier 64 can be combined with the amplified signal AMP to effectively cancel the error signal from the output of the combiner 66.

The fixed equalizer 62 receives the output signal of the phase adjuster 60 and compensates for the non-ideal frequency response of the correction amplifier 64 by modifying the characteristics of the input signal of the correction amplifier 64. The correction amplifier 64 amplifies the output of the fixed equalizer 62 according to a predetermined gain to generate a cancellation signal CS. That is, the combination of the equalizer 62 and the correction amplifier 64 then generates a cancellation signal CS having a substantially flat frequency response.

The combiner 66 receives the amplified signal AMP from the second delay unit 68 at the same time it receives the cancellation signal CS. At this time, the error component of the amplified signal AMP and the cancellation signal CS have the same initial amplitude, but are 180° out-of-phase with each other. The combiner 66 combines the amplified signal AMP and the cancellation signal CS to cancel the error component of the amplitude signal AMP using the cancellation signal CS. As a result, an amplified signal with a more linear amplitude response and a more flat frequency response is output from the feedforward amplifier 40A.

The predetermined delay time of the second delay unit 68 corresponds to the process time of the subtracter 56, the amplitude adjuster 58, the phase adjuster 60, the fixed equalizer 62, and the correction amplifier 64, so that the amplified signal AMP and the cancellation signal CS are input to the combiner 66 at the same time.

In the first embodiment of the present invention, the voltage controllable equalizer 48 is included in the first loop L1 and the fixed equalizer 62 is included in the second loop L2. However, variations thereof in accordance with the embodiments of the present invention are contemplated as part of the present invention. Different types and number of equalizers can be used in the feedforward amplifier according to the present invention depending on the fluctuations in parameters, e.g., temperature, input signal, etc., to obtain the optimum efficiency of the feedforward amplifier.

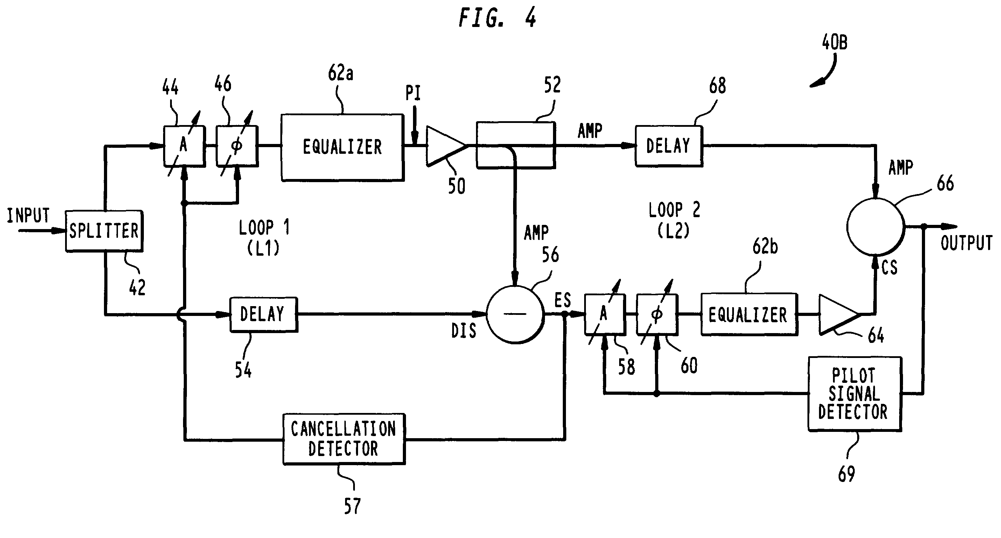

For example, according to the second embodiment of the present invention, the feedforward amplifier 40B as shown in Fig. 4 includes two fixed equalizers 62a and 62b in addition to having certain same elements as the feedforward amplifier 40A as indicated by the same reference numerals. The fixed equalizers 62a and 62b are the same as the fixed equalizer 62 in Fig. 3 in that their parameters cannot be altered once they have been set during the manufacturing stage. Therefore, the fixed equalizers 62a and 62b conditions the input signal to the main and correction amplifiers 50 and 64, respectively, according to the fixed characteristics of the equalizers 62a and 62b, to compensate for the non-flat frequency response of the main and correction amplifiers 50 and 64.

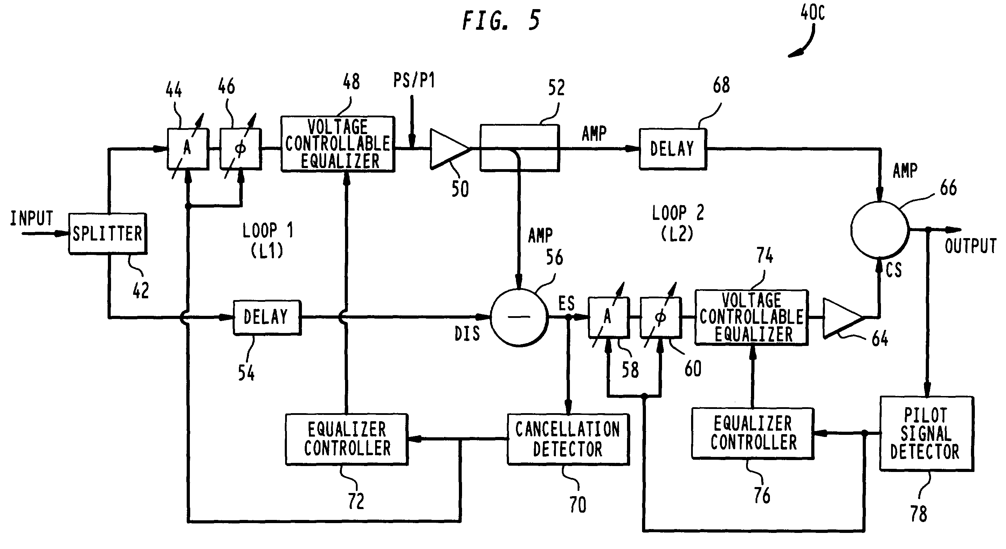

According to the third embodiment of the present invention as shown in Fig. 5, the feedforward amplifier 40C includes two voltage controllable equalizers 48 and 74 in addition to having certain same elements as the feedforward amplifier 40A as indicated by the same reference numerals. The feedforward amplifier 40C further includes a pilot signal detector 78 and an equalizer controller 76 for variably controlling the voltage controllable equalizer 74.

The voltage controllable equalizer 48 adjusts the input signal of the main amplifier 50 to compensate for the non-flat frequency response of the main amplifier 50 under control of the equalizer controller 72 as discussed in the first embodiment. At the input of the main amplifier 50, a pilot signal PS, resembling an error component of the amplified signal, is injected., This pilot signal PS differs from the pilot signal PI used in the previous embodiments in that the pilot signal PI is a pulse at a fixed frequency whereas the pilot signal PS is composed of a plurality of different signal segments at different frequencies. Preferably, the pilot signal PS may be two pulses at frequencies just outside the two ends of the frequency range used by the main signal being input to the amplifier 50. In the alternative, the pilot signal PS may be a jumping signal staying at different frequencies for a short period of time, simultaneously generated multiple pulses having frequencies outside and near the two ends of the frequency range used by the main signal input to the amplifier 50, or multiple pulses within the frequency range of the main signal at frequencies where there are no signals present. Use of the pilot signal PS at just outside the frequency range of the main signal provides adequate data for the controller 76 to adjust the equalizer 74 to be used within the frequency range of the main signal. Other variations of the pilot signal PS may be contemplated as part of the present invention.

The pilot signal detector 78 also detects a pilot signal PI, injected at the input of the main amplifier 50, at the output of the combiner 66, and controls the amplitude and phase adjusters 58 and 60 using the pilot signal PI, similar to the pilot signal detector 69 of Fig. 3. Further, the pilot signal detector 78 detects the pilot signal PS at the output of the combiner 66, this detection being used by the equalizer controller 76 to voltage-control the equalizer 74 to minimize the non-flat frequency response component of the error signal ES. The pilot signal PI is used to control the gain and phase adjusters 58 and 60 whereas the pilot signal PS is used to control the equalizer 74. As a variation, a portion, e.g., a pulse, of the pilot signal PS may be used as the pilot signal PI to control the amplitude and phase adjusters 58 and 50. Accordingly, the combiner 66 outputs an ideally amplified signal with a minimum error signal.

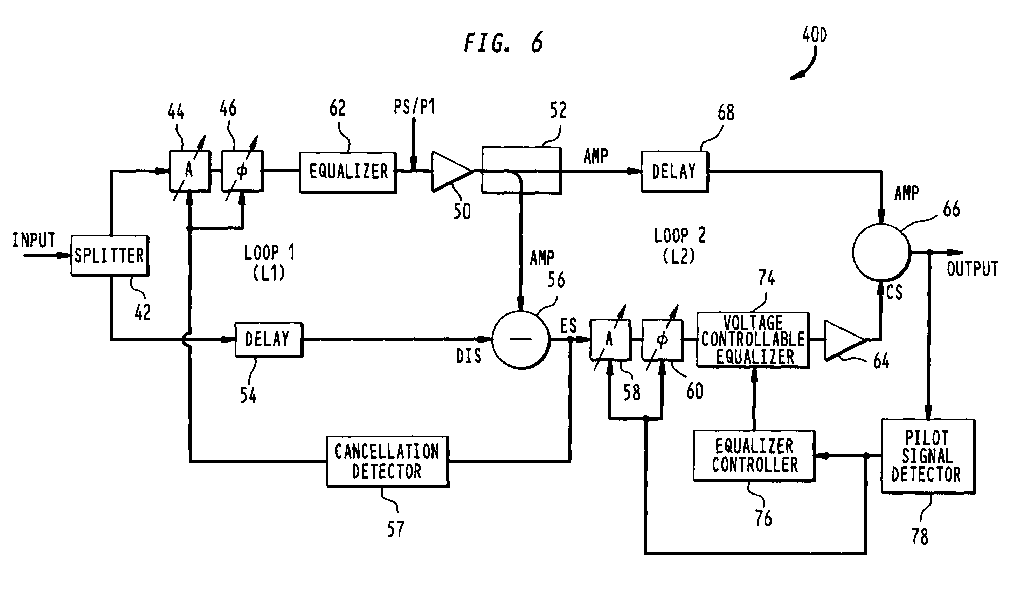

According to the fourth embodiment of the present invention as shown in Fig. 6, the feedforward amplifier 40D includes the fixed equalizer 62 in the first loop L1 and the voltage controllable equalizer 74 in the second loop L2. In addition, the feedforward amplifier 40D includes certain same elements as the feedforward amplifier 40A as indicated by the same reference numerals. The fixed equalizer 62 modifies the input signal of the main amplifier 50 according to the fixed parameters of the equalizer 62 to compensate for the non-flat frequency response of the main amplifier 50. The pilot signal detector 78 detects the pilot signal PI at the output of the combiner 66 similar to the pilot signal detector 69 in Fig. 3. Further, the pilot signal detector 78 detects the pilot signal PS injected at the input of the main amplifier 50, and the equalizer controller 76 voltage-controls the voltage controllable equalizer 74 based on the detection by the detector 78, as discussed in the third embodiment, to minimize the non-flat frequency response component of the error signal prior to being input to the correction amplifier 64.

In still other embodiments, only one equalizer is provided in the feedforward amplifier. This equalizer may be placed either in the first or second loop L1 or L2, and can be either the fixed equalizer 62 or the voltage controllable equalizer 48 or 74 provided with the associated equalizer controller 72 or 76 and the detector 70 or 78.

Furthermore, each of the equalizer controllers 72 and 76 can include a digital signal processor (DSP) for implementing computer algorithms (programs), given the detection signal from the detectors 70 and 78, to generate voltage control signals for the equalizer that will result in the optimum efficiency of the feedforward amplifier.

According to the present feedforward amplifier and its amplification method, the frequency equalization function of the feedforward amplifier is separated from its linearizing function, and performed by an equalizer positioned at the input of a main and/or correction amplifier. This allows a smaller and less powerful amplifier to be used as the correction amplifier 64 and a less expensive amplifier to be used as the main amplifier 50. Therefore, the cost and size of the feedforward amplifier according to the embodiments of the present invention are reduced significantly compared to conventional feedforward amplifiers, and a more efficient feedforward amplifier and amplification method with a greater operational bandwidth is provided.

## Claims

1. A feedforward amplifier comprising:
a first circuit for receiving an input signal, generating a fast amplified signal based on the input signal, and separating an error signal from the first amplified signal;
a second circuit, coupled to the first circuit, for generating a cancellation signal based on the separated error signal and combining the first amplified signal and the cancellation signal to generate a second amplified signal; and
at least one equalizer, positioned in at least one of the first and second circuits, for controlling a non-flat frequency response component of the second amplified signal.

2. The feedforward amplifier of claim 1, wherein said at least one equalizer includes a first type equalizer placed in at least one of the first circuit and the second circuit.

3. The feedforward amplifier of claim 2, wherein the first type equalizer is a voltage controllable equalizer having adjustable characteristics.

4. The feedforward amplifier of claim 2, wherein the first type equalizer is a fixed equalizer having fixed characteristics.

5. The feedforward amplifier of claim 1, wherein said at least one equalizer includes a first equalizer in the first circuit and a second equalizer in the second circuit, the first and second equalizers having fixed characteristics.

6. The feedforward amplifier of claim 1, wherein said at least one equalizer includes a first equalizer in the first circuit and a second equalizer in the second circuit, the first and second equalizers having adjustable characteristics.

7. The feedforward amplifier of claim 3, further comprising:
an equalizer controlling unit for controlling the adjustable characteristics of the voltage controllable equalizer.

8. The feedforward amplifier of claim 7, wherein the equalizer controlling unit includes:
a detector for receiving the separated error signal from the first circuit and detecting a frequency response of the error signal to generate a detection signal; and
a controller for varying the adjustable characteristics of the voltage controllable equalizer based on the detection signal.

9. The feedforward amplifier of claim 1, wherein the first circuit includes:
a splitter for dividing the input signal into a first divided input signal and a second divided input signal; and
an adjustment unit for adjusting a gain and phase of the first divided input signal.

10. The feedforward amplifier of claim 9, wherein the first circuit further includes:
a delay unit for delaying the second divided input signal from the splitter for a predetermined time period; and
a subtracter for receiving an output of the delay unit and subtracting the output of the delay unit from the first amplified signal to separate the error signal.

11. The feedforward amplifier of claim 1, wherein the second circuit includes:
a delay unit for delaying the first amplified signal for a predetermined time period;
an adjustment unit for varying a gain and phase of the error signal output from the first circuit; and
a correction amplifier for amplifying the error signal to output the cancellation signal.

12. The feedforward amplifier of claim 11, wherein the second circuit further includes a combiner for combining an output of the delay unit with the cancellation signal output from the correction amplifier to generate the second amplified signal.

13. A feedforward amplification method comprising the steps of:
separating an error signal from a first amplified signal;
generating a cancellation signal based on the error signal;
combining the first amplified signal and the cancellation signal to generate a second amplified signal; and
compensating, using at least one equalizer, a non-flat frequency response component of the second amplified signal.

14. The amplification method of claim 13, wherein said separating step includes the step of adjusting a gain and phase of an input signal to be amplified; and said compensating step includes the steps of controlling a frequency response of the gain and phase adjusted signal output from said adjusting step.

15. The amplification method of claim 13, wherein said compensating step includes the steps of:
detecting a frequency response of the error signal;
generating control signals based on a result from said detecting step; and
adjusting parameters of the at least one equalizer based on the control signals.

16. The amplification method of claim 13, wherein said generating step includes the step of adjusting a gain and phase of the error signal; and said compensating step varies characteristics of the gain and phase adjusted error signal output from said adjusting step to compensate for the non-flat frequency response component of the second amplified signal.

17. A computer program embodied on a computer-readable medium for adaptively controlling an equalizer included in a feedforward amplifier, the computer program comprising:
a first source code segment for detecting an error signal included in an amplified signal generated in the feedforward amplifier; and
a second source code segment for generating a control signal based on the detection result to minimize a non-flat frequency response component of the error signal, and applying the control signal to the equalizer.

18. The computer program of claim 17, wherein the equalizer is a voltage controllable equalizer.

19. A computer program embodied on a computer-readable medium for adaptively controlling an equalizer included in a feedforward amplifier, the computer program comprising:
a first source code segment for detecting a pilot signal in an amplified signal generated in the feedforward amplifier; and
a second source code segment for generating a control signal based on the detection result to minimize a non-flat frequency response component of the pilot signal, and applying the control signal to the equalizer.

20. The computer program of claim 19, wherein the equalizer is a voltage controllable equalizer.

21. The computer data signal of claim 19, wherein the pilot signal is composed of a plurality of pulses at different frequencies.
